# EUROPEAN PATENT APPLICATION

(11) **EP 1 220 309 A1**
(43) Date of publication of application: **03.07.2002**
(21) Application number: 00830854.6
(22) Date of filing: 28.12.2000
(51) Int. Cl.: H01L 21/56

(54) **Manufacturing method of an electronic device package**

(71) Applicant: STMicroelectronics S.r.l., 20041 Agrate Brianza (Milano) (IT)
(72) Inventor: Magni, Pierangelo, 20058 Villasanta (Milano) (IT); Cigada, Andrea, 20047 Brugherio (Milano) (IT)
(74) Representative: Botti, Mario

(57) **Abstract**

A method for forming a protective package (11a) made out of plastic material for an electronic device integrated on semiconductor, and comprising an electronic circuit (13) that can be at least partially activated from the outside of the protective package (11a) and that is to be encapsulated in its turn in said protective package (11a), characterized in that:
- it provides the use of a mold (10), comprising a half-mold (11) having a lug (17) abutting towards the inside of the mold, and comprising an end having an element (17) that can be elastically deformed and that abuts in pressing contact against at least one portion of the integrated circuit (13);
- it injects the resin in the mold so that said protective package has a hole by said portion of said electronic circuit.

## Description

### Application Field

The present invention makes reference to a method for manufacturing a protective package of an electronic device, particularly of a pressure sensor of the optic type and similar ones.

More specifically the invention makes reference to a method for forming a protective package made out of plastic material for an electronic circuit integrated on semiconductor and comprising an electronic circuit that can be at least partially activated from the outside of the protective package and that is to be encapsulated in its turn in said protective package.

Furthermore, the invention makes reference to a mold for molding a plastic protective package encapsulating an integrated electronic circuit that can be at least partially activated from the outside of said protective packaging, the mold being formed by a pair of half-molds laid one on the other to make a space for containing the integrated circuit.

The invention particularly relates, but not exclusively, to a method for forming a protective package made out of plastic material, for an integrated electronic device of the type having a window to access the electronic device at least partially, and the following description is made with reference to this application field, with the only aim to simplify its explanation.

### Prior Art

As it is well known, during the last years semiconductor electronic devices comprising pressure sensors or of the optic type, have become more and more important and used.

For these types of electronic devices it is necessary to form packages having a window that allows to access the active portion of the electronic device, that is that portion which comprises the sensor.

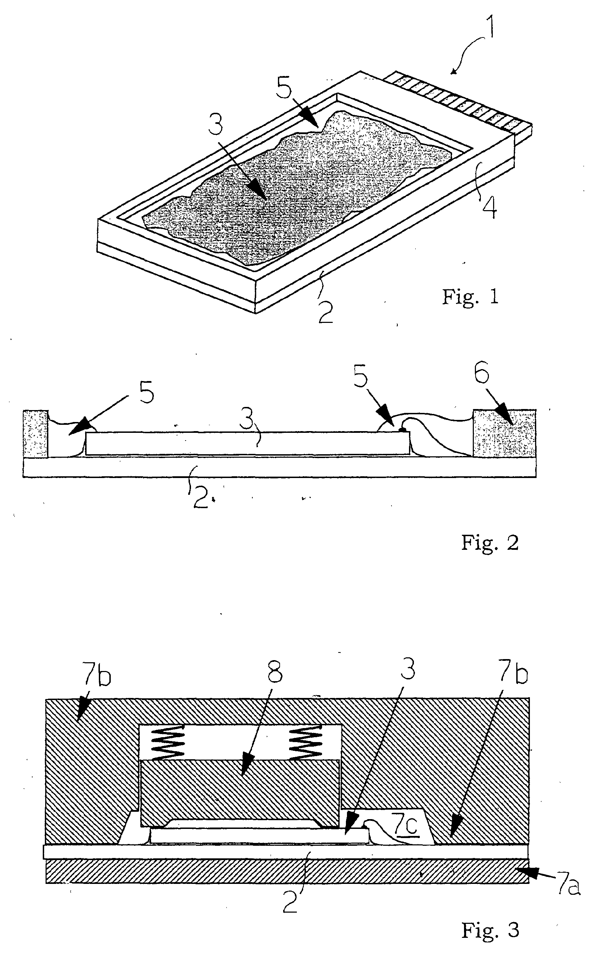

In figure 1 a prospective view of a package 1 is shown, for an electronic device of the above type and formed according to a first known method. Beginning from a substrate 2, for example made of semiconductor material, dies made of semiconductor material are formed, comprising an electronic circuit 3. Such dies are encapsulated by a package 4 made out of plastic material which leaves a portion of the electronic circuit 3 uncovered. For example, an overmolding technique is used to form the package 4, such that a liquid epoxy resin 5 is dispensed on the substrate 2 and on the perimeter of the electronic circuit portion that needs to be left uncovered.

This first method is advantageous from many points of view, but it also shows some drawbacks. In fact, this method does not produce regular surfaces like the ones formed by applying the traditional molding method. Moreover, the dimensions of these packages are not completely checkable and the resin depositing process is not easily repeatable, specially on the electronic circuit surface.

Indeed, a second method provides the use of dames 6, which are placed on the substrate 2, as it can be seen in the section view of a package shown in figure 2. The liquid epoxy resin is then dispensed between the dames, the substrate and the electronic circuit perimeter.

Although this solution reaches the proposed aim, it presents some disadvantages. In fact, also in this case the resin outline on the integrated circuit surface can not be maintained constant during the production cycle.

Recently methods using standard molding techniques, also for the production of packages with window, have been introduced.

In figure 3 it is shown a sectional view of a mold 7 that comprises a half-mold 7a and a half-mold 7b, which show, when they are laid one on the other, a space 7c for containing the electronic device 3. According to this prior art, the upper half-mold 7b internally comprises a sprung clamp 8, placed in a position almost corresponding to the portion of the electronic circuit to be left uncovered. Such sprung clamp 8 has a basically parallelepipedic form and is slidingly placed in a recess of the upper half-mold 7b. The sprung clamp 8 is stressed by elastic elements, as for example springs. When the half-mold 7b is laid on the half-mold 7a, the sprung clamp 8 abuts against the device surface to be left empty. A molten epoxy resin at high temperature is then injected in the mold, so forming the plastic package.

Although this method is advantageous under many points of view, it presents the drawback of damaging the circuit operation. In fact the force to impress on the two half-molds during the reciprocal coupling, in order not to have the resin pouring out of the molds when the injection occurs, is of about 10-30 tons. Indeed, the force of the sprung clamp abutting down against the electronic circuit does not have to be higher than 100 Kilos, in order to avoid the damaging of the electronic circuit 3.

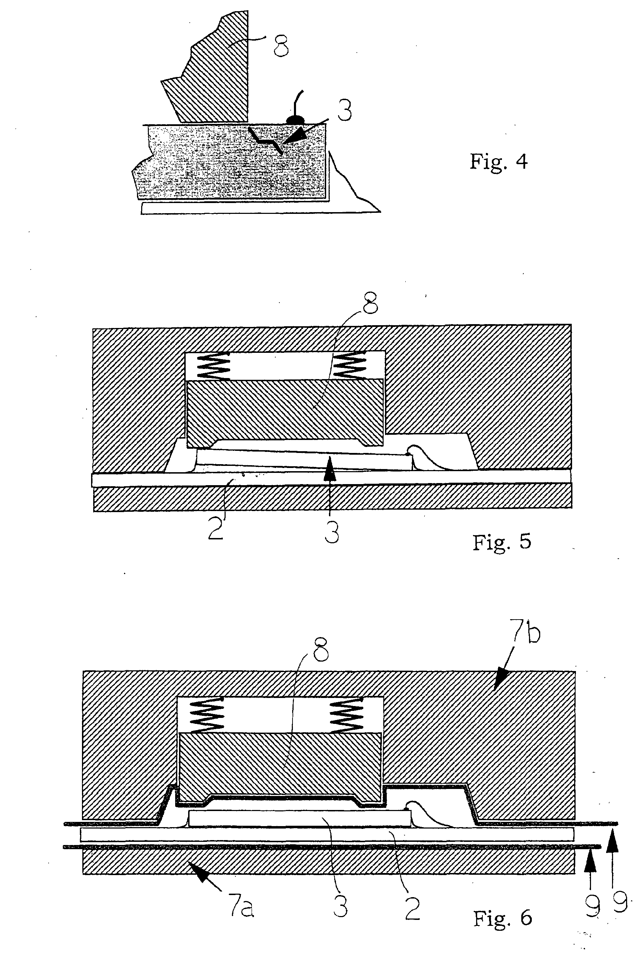

The presence of the sprung clamp partially allows the force used by the floating clamp abutting against the electronic circuit to be modulated. Nevertheless, the direct contact of the metallic clamp against the circuit active surface can damage the functionality of the circuit, as shown in figure 4.

A further drawback occurs when the electronic circuit is tilted on the clamp surface, as shown in figure 5. In fact, the method shows an unwelcome resin infiltration during the mold filling phase, and the electronic circuit surface, which is not perfectly parallel to the support, is damaged.

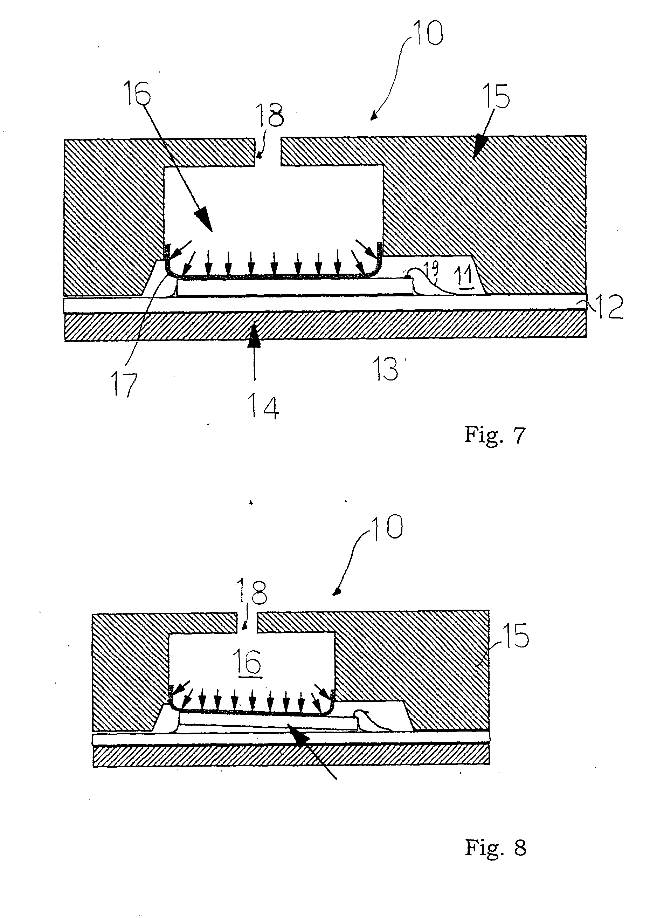

It has been suggested to coat the mold and the sprung clamp with a film tape 9, as shown in figure 6, in order to reduce the possibility of damaging the electronic circuit during the two half-molds coupling. Nevertheless, this method can correct only small irregularities of the integrated circuit. The film tape 9 must be also substituted at every new production phase, thereby increasing the production costs.

Further, the uniform deposition of the film tape on the half-mold is very critical.

Furthermore, the mold used in conventional molding techniques provides a plurality of mold shapes having adjacent cavities, in order to simultaneously form a plurality of packages.

Therefore, the sprung clamp must be introduced into the mold as many times as many are the devices to be molded. All these inserts increase the possibility of having part of the resin filling the spaces between the mobile portions during the mold filling phase, thereby causing a jam or a yield reduction of the resin to be deposited on the integrated circuit surface.

The technical problem at the basis of the present invention is the one of providing a method for manufacturing protective packages with window, presenting features such to overcome the manufacturing method drawbacks of the prior art.

### Summary of the invention

The resolutive idea at the basis of the present invention is the one of forming protective packages for electronic devices, by using a mold provided with a lug. Advantageously, such a lug also comprises an elastic membrane fitting itself to the integrated circuit surface, when the mold closes down. In particular, the membrane is stressed, by means of a pressured fluid, towards and in pressing contact against the circuit. In such a way, during the injection phase of the insulating material, a window in the package by the membrane is formed.

On the basis of such resolutive idea, the technical problem is solved by a method of the type previously indicated and disclosed by the characterizing part of claim 1.

The problem is also solved by a mold of the type previously indicated and disclosed by the characterizing part of claim 5.

The features and the advantages of the method according to the invention will be apparent in the following description, of a mold for its formation, given by way of non-limitative example with reference to the accompanying drawings.

### Brief description of the drawings

In such drawings:
- figure 1 shows a schematic prospective view of a protective package for a prior electronic device;
- figure 2 shows a sectional view of a prospective package for a prior electronic device;
- figure 3 shows a sectional exploded view of a mold for a protective package of an electronic device, according to the prior art;
- figure 4 shows a particular of the protective package, formed according to the prior art;
- figure 5 shows a sectional exploded view of a mold for a protective package in another operation condition;
- figure 6 shows a sectional exploded view of a mold according to the prior art;
- figure 7 shows a sectional exploded view of a mold for a protective package of an electronic device according to the invention;
- figure 8 shows a sectional view of the mold according to the invention in another operational condition;
- figure 9 to 12 show a mold during the phases of forming a protective package according to the invention.

### Detailed description

With reference to the figures 7 and 8, a mold formed according to the invention is shown at 10, for obtaining a protective package 11a with a window. The mold 10 shows a space 11 containing the electronic circuit 13, for injecting an insulating material, for example resin.

In the figures it is shown a vertical section of only one mold delimiting only one cavity, even though in conventional molding techniques the mold has a plurality of adjacent cavities for simultaneously forming a plurality of packages.

Inside the containing space 11 a lead frame 12 is placed, for example a metallic leaf, on a plastic substrate, a ceramic substrate, on which an electronic circuit 13 is fastened, comprising for example a proximity sensor, of the touch type or of the optic, pressure, fingerprints identification type, and similar.

The following description makes reference to these types of sensor. The invention can obviously be applied to all the electronic devices that must have a surface portion in direct communication with the outside of the package, even though they are encapsulated in a protective package.

Basically, the mold 10 comprises two half-parts: a half-mold, or lower half-shell 14, and a half-mold, or upper half-shell 15, which form a space 11 for containing the electronic circuit 13 when they are closed.

According to the invention, the upper half-mold 12 has a lug which is formed of an element 17 made out of a material that can be elastically deformed, abutting in pressing contact against the electronic circuit 13.

In a preferred embodiment, the upper half-mold 12 has a cavity 16 that is substantially delimited by the half-mold 12 and by the element 17, made out of a material that can be elastically deformed.

Advantageously, the element 17 is an elastic membrane. Such membrane 17 is preferably made out of an elastomer.

In an embodiment the membrane 17 is glass shaped and is obtained by molding, for example. Said membrane comprises a cylindrical skirt 17a and a bottom 17b.

At least one portion of the cylindrical skirt 17a is maintained against the walls of the cavity 16.

In such a way the cavity 16 is in communication with the outside of the mold through an opening 18.

After the two half-molds 14 and 15 have clamped together, the cavity 16 is pressure filled trough the opening 18. In such a way the bottom 17b of the membrane perfectly adheres to the circuit 13 surface and abuts in pressing contact with said circuit.

Afterwards, it is carried out the phase of forming the protective package 9, by injecting insulating material, as for example epoxy resin, in the space 11.

This is followed by different thermodynamic processes of polymerization and resin curing.

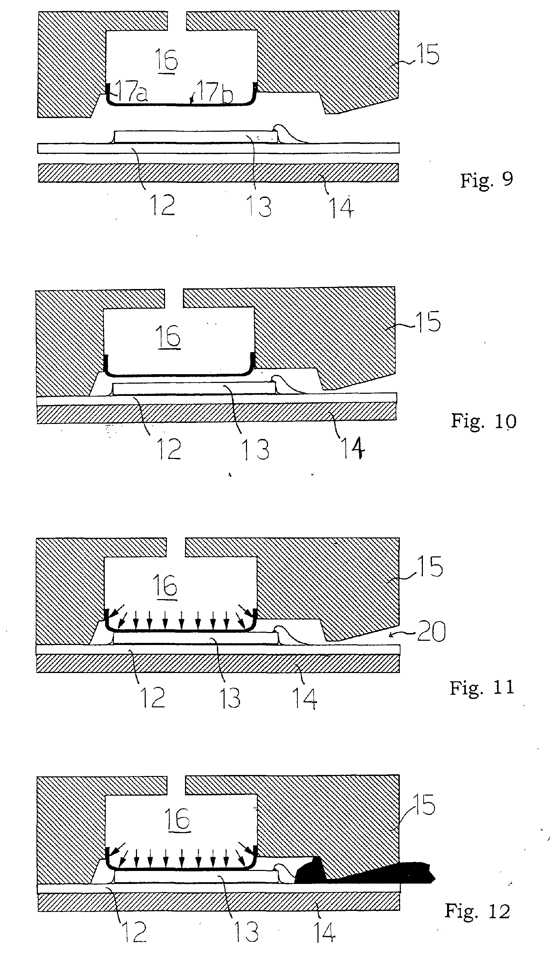

With reference to the figures 9 to 12, the method of forming a plastic protective package is now described according to the invention.

In all these figures, with 12 it is indicated a metallic lead frame on which a die is mounted, in such die having been formed an integrated circuit 13.

The integrated circuit 13 comprises for example a sensor which can be activated from the outside of the protective package 11a and connected to a control circuitry. The electronic circuit is connected to pins through thin conductor wires 19 for the outer electric connection.

Advantageously, the lead frame 12 is positioned on the bottom of the molding cavity, and particularly in the hollow made by the lower half-mold 14.

The lead frame 12 can also be placed in the middle of the containing space 11.

According to the invention, once the lead frame is placed on the lower half-mold 14, the upper half-mold 15 is then laid upon the lower half-mold 14, so that a containing space 11 between the two half-molds is obtained, as shown in figure 10.

As it has already been said in the prior art, a pressure is exerted to the two half-molds such that these are clamped together when the material for forming the protective package is injected, according to the invention.

When the upper half-mold 12 is fastened to the lower half-mold 11, the membrane 17 is not in contact with the integrated circuit 13.

According to the invention, the cavity 16 of the mold 10 delimited by the membrane 17, is filled with a pressure fluid at a predetermined value.

The fluid pressure is then regulated at a suitable value. In particular, the fluid pressure inside the cavity 16 is higher than the pressure at which the resin is injected in the mold for forming the package of plastic material. For such purpose, the best results are obtained at a fluid pressure in the field from 60 to 70 Mpa.

In such a way the pressure of the fluid applied to the membrane 17 allows the bottom 17b of the membrane to abut in pressing contact against the surface of the circuit 13 which has to be exposed, guaranteeing its seal from infiltrations.

In particular, a surface of the bottom 17b is stressed by the pressing force, while the opposite surface of the bottom 17b is in pressing contact against the electronic circuit 13, leaving the entire boarder of the electronic circuit uncovered. In such a way the protective package will completely cover the circuit 13 border.

As shown in the figures, the membrane 17 can cover also a side of the electronic circuit 13. In this way, the protective package of the invention will cover only the circuit 13 border which is left free from the membrane 17.

Afterwards, the phase of forming the protective package 11a is carried out.

A molten plastic material, for example an epoxy resin at high temperature, is pressure injected in the cavity made between the half-molds through an injection opening 20 and through suitable channels that are not represented.

The presence of the membrane 17 is such that it becomes a barrier to the stream of insulating material during the injection. The final protective package is then provided with a window or hole aligned with the integrated circuit 13.

To conclude, the method of the invention avoids the direct contact of metallic parts against the active part of the integrated circuit 13.

A further advantage of the method according to the invention overcomes any possible misalignment of the integrated circuit 13, due for example to the faulty planarity of the substrate or of the surface of the integrated circuit, with the presence of the flexible membrane.

Further, the inventive mold allows a greater number of packages to be formed, compared to the number of packages formed according to the prior art, and allows to use manufacturing processes with improved tolerances.

Further, the inventive mold allows to simplify the formation of the mold, by removing all its mobile mechanical parts.

Advantageously, with the mold and the method according to the invention it is possible to adapt the intensity of the pressing contact against the integrated circuit from time to time during the production, thereby regulating the fluid pressure.

## Claims

1. A method for forming a protective package (11a) made out of plastic material for an electronic device integrated on semiconductor, and comprising an electronic circuit (13) that can be at least partially activated from the outside of the protective package (11a) and that is to be encapsulated in its turn in said protective package (11a), **characterized in that**:
- it provides the use of a mold (10), comprising a half-mold (11) having a lug (17) projecting towards the inside of the mold, and comprising an end having an element (17) that can be elastically deformed and that abuts in pressing contact against at least one portion of the integrated circuit (13);
- it injects the resin in the mold so that said protective package has a hole aligned with said portion of said electronic circuit.

2. A method according to claim 1, **characterized in that** said element 17, which can be elastically deformed, is pressure pressed against the electronic circuit (13).

3. A method according to claim 2 **characterized in that** said element (17), which can be elastically deformed, abuts in pressing contact against at least a border portion of the integrated circuit (13).

4. A method according to any of the previous claims, **characterized in that** it comprises the following phases:
- positioning the integrated circuit (13) in the half-mold (15), including said element (17), which can be elastically deformed;
- having a force acting on a surface of said element (17), which can be elastically deformed, so that the opposite surface of said element (17) is pressed against at least one portion of the integrated circuit.

5. A mold (10) for molding a plastic protective package (11a) encapsulating an integrated electronic circuit (13), that can be at least partially activated from the outside of said protective package (11a), the mold being formed by a couple of half molds (14, 15) which are laid one on the other to form a space (11) for containing the integrated circuit, **characterized in that** a half-mold (15) has a lug (17) projecting substantially towards by said electronic circuit (13), said lug being provided with an element (17), which can be elastically deformed, abutting in pressing contact against at least a portion of the electronic circuit (13) during the molding phase.

6. A mold (10) for molding a protective package (11a) according to claim 5, **characterized in that** said element (17), which can be elastically deformed, is a membrane.

7. A mold (10) for molding a protective package (11a) according to claim 5, **characterized in that** said membrane (17), along a first membrane surface, is in pressing contact against the electronic circuit, and a fluid acts on the opposite surface, stressing said membrane (17) against the electronic circuit (13).
